# EUROPEAN PATENT APPLICATION

(11) **EP 4 851 815 A1**
(43) Date of publication of application: **09.12.2026**
(21) Application number: 25180458.9
(22) Date of filing: 03.06.2025
(51) Int. Cl.: G06F 13/40, B60R 16/023

(54) **MODULAR COMPUTER SYSTEM FOR A VEHICLE**

(71) Applicant: VOLVO CAR CORPORATION, 405 31 Göteborg (SE)
(72) Inventor: JANISZEWSKI, Marcin, 433 52 ÖJERSJÖ (SE); MARTIN GONZALEZ, David, 417 29 GÖTEBORG (SE)
(74) Representative: Kransell & Wennborg KB

(57) **Abstract**

A modular computer system (100) for a vehicle, comprising: a main circuit board (102) comprising a processing unit (104), the main circuit board being configured to perform computation and control functions in a vehicle; an input/output circuit board (106), configured to perform input and output operations for vehicle-specific functions; and a board-to-board interface connecting (108) the main circuit board and the input/output circuit board, wherein the main circuit board and the input/output circuit board are functionally and physically separate, and the input/output circuit board is configured to provide electrical and mechanical interfacing (110) between the vehicle and the main circuit board.

## Description

### TECHNICAL FIELD

The present disclosure relates to electronic systems for vehicles, and in particular to modular architectures for vehicle-mounted computing devices.

### BACKGROUND

Modern vehicles rely on a variety of electronic systems to support control, communication, sensing, and actuation functions. These systems are typically implemented using electronic control units (ECUs), which are designed to manage specific domains such as powertrain, body control, infotainment, and advanced driver assistance.

As vehicle functionality expands and system integration increases, the design and deployment of ECUs become more complex. This complexity presents challenges in terms of scalability, maintainability, and the efficient adaptation of electronic systems to varying vehicle configurations and performance requirements.

### SUMMARY

In general, the disclosed subject matter relates to modular computing systems used in vehicular electronic control environments. Such systems are increasingly relied upon to perform both computational tasks and physical interfacing with vehicle subsystems. In complex vehicle architectures, there is a growing need for a modular and adaptable hardware approach that can support various performance levels and vehicle-specific interface configurations without requiring a complete redesign of the underlying control electronics.

According to a first aspect of the invention, there is provided a modular computer system for a vehicle, comprising: a main circuit board comprising a processing unit, the main circuit board being configured to perform computation and control functions in a vehicle; an input/output circuit board, configured to perform input and output operations for vehicle-specific functions; and a board-to-board interface connecting the main circuit board and the input/output circuit board, wherein the main circuit board and the input/output circuit board are functionally and physically separate, and the input/output circuit board is configured to provide electrical and mechanical interfacing between the vehicle and the main circuit board.

The technical problem addressed by this aspect arises from the limitations of conventional ECU designs, which typically integrate processing and input/output functions on a single circuit board. This integration restricts flexibility, complicates upgrades or reconfiguration, and limits reuse across different vehicle platforms. There is a need for a design that enables the independent scaling, replacement, or adaptation of processing and interfacing components while maintaining reliable interconnection and consistent system behavior.

The solution to this problem is achieved by functionally and physically separating the processing unit and vehicle-specific input/output hardware into distinct circuit boards connected via a standardized board-to-board interface. This interface enables interoperation of different processing boards with different IO boards without requiring custom adaptation, thereby allowing the system to be modular and reusable.

Advantageous effects of the invention include enhanced design flexibility, improved hardware reuse across vehicle lines, simplified adaptation to varying performance requirements, and reduced time-to-market for updated configurations. Furthermore, the modular approach facilitates platform scalability and supports efficient integration of technological advancements without impacting the entire control system architecture.

According to an example, the input/output circuit board is configured to receive main circuit boards having different configurations. This allows the same input/output board to support a variety of main circuit boards that may differ in processing power, component population, or physical layout, provided they conform to a shared interface standard. Conversely, a main circuit board may also be reused with multiple input/output boards designed for different vehicle applications or system variants. Such bidirectional modularity enables flexible combinations of processing and IO configurations, allowing, for example, two differently configured main circuit boards to interface with a common input/output board, or a single main circuit board to support multiple IO-specific boards. This architecture is particularly advantageous when implementing platform upgrades, as either the main circuit board or the input/output board may be updated independently, depending on the technical or functional evolution required. The system thus supports scalability, reusability, and cost-effective hardware modularity across diverse vehicle lines and product lifecycles.

According to an example, the input/output circuit board comprises a plurality of board-to-board interfaces. This design enables parallel or segmented control by connecting multiple processing boards, each potentially addressing different IO groups or system partitions. It supports high-performance configurations and facilitates separation of functional domains within the same physical ECU housing. In some implementations, it is also possible to provide software-based separation within the same processing unit.

According to an example, the processing unit is selected from a group of programmable processing devices comprising a microcontroller unit (MCU), microprocessor unit (MPU), system on a chip (SoC), and field programmable gate array (FPGA). The use of a diverse set of programmable platforms provides design flexibility, allowing the system to be optimized for cost, performance, or software compatibility depending on the target application.

According to an example, the programmable processing device is selected based on a required computational capability of the main circuit board, wherein the required computational capability is dependent on a vehicle-specific function which the computer system is configured to perform. This alignment between function-specific needs and processing capability supports efficient resource allocation, reduces overdesign, and optimizes system performance for each target ECU configuration.

According to an example, the main circuit board further comprises at least one of: a power management integrated circuit (PMIC); a system basis chip (SBC); a power supply; and a crystal/oscillator. Integrating the described components and functions ensures that the main circuit board has autonomous power control, clocking, and base-level hardware management, allowing it to operate as a fully functional and replaceable computing unit. This also improves reliability and decouples dependencies on the IO board for critical startup or standby behavior.

According to an example, the input/output circuit board comprises at least one of: a mechanical interface for connecting the input/output circuit board to a vehicle wiring harness; a power supply and distribution section; an analog and/or digital input section; a load control section; a communication interface section; a wireless communication section; a wake-up signal management section; and a latch and fail-safe control section. This comprehensive functionality allows the input/output board to serve as the primary vehicle interface, enabling support for sensing, actuation, communication, diagnostics, and safety functions tailored to the vehicle application.

According to an example, the wake-up signal management section is configured to receive a plurality of wake-up signals from vehicle components and to generate one or more generalized wake-up signals for transmission to the main circuit board via the board-to-board interface. This centralized wake-up management facilitates flexible handling of various wake-up sources and simplifies routing of trigger signals, ensuring predictable behavior regardless of the number or nature of external inputs.

According to an example, the latch and fail-safe control section is configured to maintain operation of selected output functions on the input/output circuit board in response to a predefined vehicle condition when the processing unit on the main circuit board is inactive or non-operational. This configuration allows the system to retain control over designated vehicle outputs even when the central processing unit is unavailable due to faults, resets, or sleep modes. By shifting responsibility for certain critical control paths, such as lighting, actuation hold states, or communication handshakes, to the input/output circuit board, the architecture achieves functional decoupling of essential outputs from the processing logic. This improves system reliability, especially in scenarios involving processor recovery or reinitialization, and supports safe fallback behaviors. The predefined vehicle conditions may include diagnostic triggers, lowvoltage states, or software transitions, allowing the system to respond autonomously to ensure continuity of function. This supports fail-operational behavior, reduces dependency on continuous processor availability for basic IO operations, and enhances compliance with automotive functional safety requirements.

According to an example, the latch and fail-safe control section is configured to maintain power to at least one vehicle load via the input/output circuit board in a limp-home mode, the limp-home mode being activated when the main circuit board is unresponsive or in a predefined fault state. This functionality ensures that key vehicle systems remain operational even in degraded conditions where the main control board has failed or is non-functional. The latch and fail-safe circuitry, being resident on the input/output board, can autonomously manage critical outputs such as exterior lighting, emergency communication systems, or limited actuation functions. The system transitions into limp-home mode based on monitored fault criteria and retains power supply and control over designated loads using predefined logic and embedded protection circuits. This is particularly valuable in safety-critical scenarios where complete loss of function is unacceptable. The described functionality thereby enables continued operation of the vehicle and improves safety by preserving access to essential systems.

According to an example, the board-to-board interface comprises a predefined arrangement of pins including: power supply lines, wake-up signal lines, and spare signal lines for functional expansion. In addition to these, the interface includes a high number of signal lines dedicated to the control, monitoring, and diagnostic communication with the components of the input/output circuit board. These may include general-purpose input/output (GPIO) lines, analog and digital control channels, pulse-width modulation (PWM) lines, communication interfaces, and other function-specific signals. The interface further includes multiple ground lines to ensure proper signal referencing and electromagnetic compatibility. Standardizing these connections ensures interoperability between different board variants, simplifies testing and validation, and reserves future expansion capacity without requiring a redesign of the interface or its associated circuit boards.

According to an example, the system is integrated in a housing configured with a vehicle-specific mechanical fixation and thermal management interface, thereby supporting mechanical compatibility across vehicle platforms while enabling cooling solutions tailored to the processing load, ensuring proper system integration, robustness, and thermal performance in diverse environments.

According to an example, the system comprises one or more main circuit boards and an input/output circuit board, and wherein each main circuit board is operatively connected to the input/output circuit board, and each main circuit board is configured to control at least one vehicle function. This multi-controller setup allows functional partitioning, redundancy, or computational distribution within a shared IO infrastructure, enhancing modularity and enabling support for complex or critical functions.

Further features of, and advantages with, the present invention will become apparent when studying the appended claims and the following description. The skilled person realize that different features of the present invention may be combined to create embodiments other than those described in the following, without departing from the scope of the present invention.

### BRIEF DESCRIPTION OF THE DRAWINGS

These and other aspects of the present invention will now be described in more detail, with reference to the appended drawings showing examples, wherein:
Fig. 1 is a schematic block diagram of a modular computer system for a vehicle.
Fig. 2 is a high-level system diagram illustrating a scalable, modular ECU architecture with standardized hardware and software components.
Fig. 3 is a schematic diagram showing an example physical layout and interconnection of components on a main circuit board and an IO-specific circuit board.
Fig. 4 is a software architecture diagram illustrating modular IO abstraction using standardized hardware-software interface layers.

### DETAILED DESCRIPTION

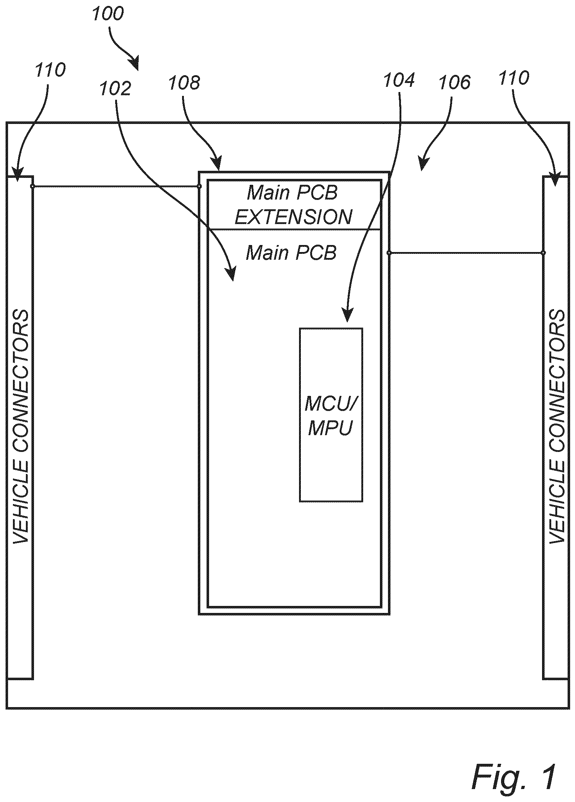

Fig. 1 illustrates a modular computer system 100 comprising a main circuit board 102 and an input/output circuit board 106. The main circuit board 102 includes a processing unit 104 configured to perform computation and control functions required by one or more vehicle subsystems. The processing unit 104 may be selected from a standardized range of programmable devices that support various performance levels and are compatible in terms of footprint and electrical interface.

The input/output circuit board 106 is configured to handle input and output operations related to vehicle-specific functions, such as sensing, actuation, communication, and power management. As illustrated, the main circuit board 102 and the input/output circuit board 106 are physically and functionally separate, allowing independent design, replacement, or scaling of processing and interface functionality. The input/output circuit board 106 provides electrical and mechanical interfacing 110 to the vehicle, including permanent connections to the vehicle wiring harness, power lines, and signal buses.

The main circuit board 102 is connected to the input/output circuit board 106 via a board-to-board interface 108. The board-to-board interface 108 is a standardized interface, meaning that its physical layout, pin configuration, and electrical characteristics are uniform across various implementations. This standardization allows different main circuit boards, potentially populated with processing units of different capabilities or from different semiconductor families, to be connected interchangeably to a given input/output circuit board 106. The interface 108 may include predefined signal lines for power supply, wake-up signaling, communication, interconnecting signal lines, ground lines, and spare lines reserved for future functional extensions. It may be implemented using board-to-board connectors, ball grid arrays, or flexible printed cable arrangements. This modular structure facilitates high reusability, ease of upgrade, and support for platform scalability across multiple vehicle lines.

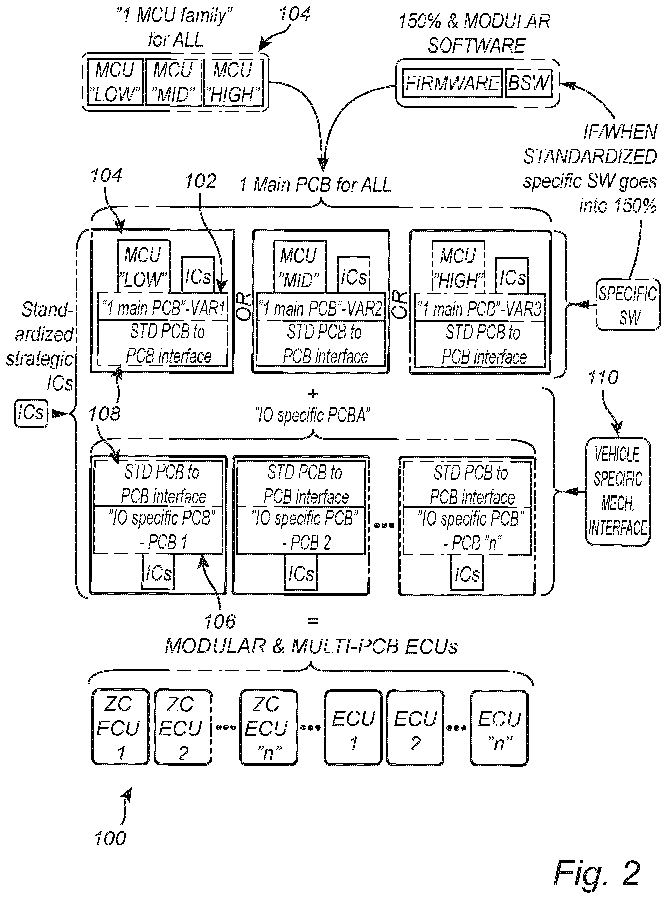

Fig. 2 illustrates an example implementation of a modular computer system 100 for a vehicle, based on a scalable, unified, and hardware-decomposed control architecture. The system comprises a set of modular components that may be flexibly configured to construct electronic control units (ECUs) suited to a range of vehicle functions and performance classes.

A standardized selection of programmable processing units 104 is employed across the architecture and is collectively referred to as a "1 MCU family" for all, denoted by reference 104. This family may comprise microcontroller units (MCUs), microprocessor units (MPUs), systems on a chip (SoCs), or field-programmable gate arrays (FPGAs), categorized according to processing performance as "LOW," "MID," or "HIGH." The selected devices are chosen to enable compatibility in terms of pin assignment, footprint, and interface behavior, facilitating seamless substitution and reuse across different ECUs within the system.

Each processing unit 104 is mounted on a main circuit board 102, referred to as a main PCB 102, which serves as the computational core of the system. Fig. 2 shows three representative variants of the main circuit board 102, each hosting a different processing unit 104 from the shared MCU family and accompanied by additional ICs required to support that device. Despite variations in population or capability, all variants are configured to connect to other system elements via a common board-to-board interface 108, which ensures electrical and mechanical compatibility across all configurations.

The main circuit board 102 is mated with an input/output circuit board 106, which is configured to perform input and output operations tailored to vehicle-specific requirements. These boards, also referred to as IO-specific PCBAs, may include circuit configurations for sensor interfacing, actuator control, communication transceivers, and power management. As illustrated in Fig. 2, each input/output circuit board 106 may support one or more instances of the standardized board-to-board interface 108, allowing multiple main circuit boards 102 with different configurations to be used interchangeably.

The architecture further incorporates a collection of standardized strategic integrated circuits that are selected for reuse across different ECU implementations. These may include communication transceivers, voltage regulators, memory components, diagnostic circuits, power drivers, and similar devices. Standardization of such ICs promotes hardware and software consistency, facilitates integration, and enhances reusability within the system.

Software associated with the modular computer system 100 follows a modular framework identified as "150 % Modular software." The 150 % Modular software can be seen as a framework comprising a comprehensive library of reusable firmware and base software modules that may be configured according to ECU-specific requirements. New or application-specific software components may be incorporated into the library following validation, thereby promoting software harmonization and efficient reuse.

All electronic components of the modular computer system 100 are physically integrated into a housing that interfaces with the vehicle structure. This housing, which forms part of a vehicle-specific mechanical interface, may include thermal management elements, standardized connector layouts, and fixation features compatible with various vehicle installations. The interface is designed to support mechanical and thermal integration across a variety of ECU variants.

Overall, the system depicted in Fig. 2 enables the construction of modular and multiboard ECUs that may be deployed across various vehicle domains, including but not limited to zone controllers, body control units, propulsion modules, and centralized compute platforms. Through the separation of computation and IO, standardization of components and interfaces, and a modular approach to software, the architecture supports efficient scaling, simplified maintenance, and rapid adaptation to evolving vehicle and platform requirements.

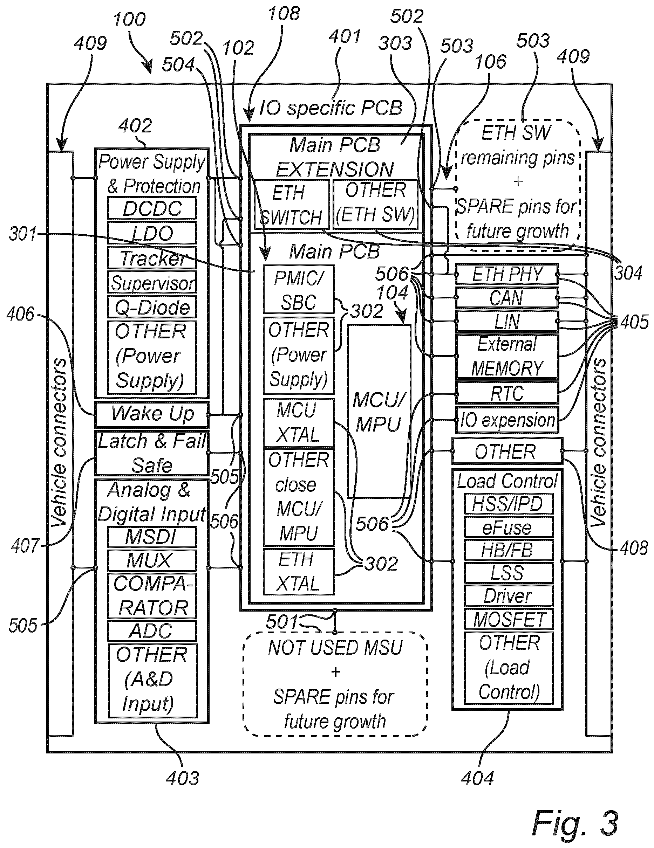

Fig. 3 is a schematic block diagram illustrating the internal structure and interconnection of components in a modular computer system 100 for a vehicle. The system comprises a main circuit board 102 and an input/output circuit board 106, both physically and functionally distinct, and interconnected via a standardized board-to-board interface.

The main circuit board 102 is principally dedicated to computational tasks and includes a processing unit, such as a microcontroller unit (MCU), microprocessor unit (MPU), system on a chip (SoC), or field-programmable gate array (FPGA), along with its associated support components 302. These may include a power management integrated circuit (PMIC) or a system basis chip (SBC), one or more crystals or oscillators, and other devices necessary for proper operation of the processing unit. The design of the main circuit board 102 deliberately avoids inclusion of components intended for vehicle-specific IO handling, except in technically justified cases such as the inclusion of an Ethernet crystal, which may be selectively populated depending on system requirements.

An optional extension region 303 may be included as part of the main circuit board. This extension may carry additional integrated circuits, such as an Ethernet switch 304 or other high pin-count or functionally dense components. The extension may be implemented as a detachable sub-region as a variant layout of the main circuit board, or by selective depopulation. Signals from the extension region are routed through the input/output circuit board via the interface section 502, 503, although in certain embodiments, direct routing between the main and extension regions may also be employed.

The input/output circuit board 106 is tailored to implement vehicle-specific functionality and hosts a series of functional blocks. A power supply and protection block 402 may comprise components such as a battery, DC-DC converters, LDO (low dropout) regulators, tracking circuits, supervisory ICs, and diode-based protection devices. This block manages power distribution within the ECU and supplies regulated voltages to both circuit boards.

An analog and digital input section 403 is used for interfacing with vehicle sensors and switches, using circuits such as analog-to-digital converters (ADC), multiplexers (MUX), comparators, and multi-switch detection interfaces (MSDI). Output control is handled by the load control section 404, which includes driver stages and protective devices such as high-side switches (HSS), low-side switches (LSS), full- and half-bridge circuits, eFuses, and other components suited for actuating and monitoring vehicle loads.

Block 405 includes interfaces such as Ethernet PHYs, CAN and LIN transceivers, external memory, real-time clocks (RTC), and IO expansion modules. These are used for both invehicle networking and internal ECU storage or signal routing.

Wake-up logic 406 aggregates incoming wake-up signals from external sources, applies the required conditioning or level conversion, and forwards generalized wake-up signals to the main circuit board over designated interface lines 505. The logic accommodates a range of trigger characteristics including level, edge, and voltage-dependent activation.

A latch and fail-safe section 407 implements circuitry capable of maintaining selected system outputs in an operational state when the main processing unit is inactive, such as during resets, faults, or defined fallback conditions. This supports fail-operational behavior including limp-home operation, as well as continuity during software downloads or transitions.

Further application-specific functionality may be integrated into a general-purpose block 408, which may house devices such as audio amplifiers, camera interfaces, ASICs, or vehicle voltage monitoring circuits. All permanent electrical connections to the vehicle, including the wiring harness, are routed through vehicle interfacing connectors 409 located on the input/output circuit board.

The standardized board-to-board interface comprises several sections. Interface region 501 may comprise unused processing unit pins and spare lines reserved for future use. The interface is dimensioned and routed to satisfy worst-case requirements in terms of signal integrity, electromagnetic compatibility, and power delivery. Interface region 502 conveys signals from the optional extension region 303 back to the main region of the main circuit board. Additional spare or unused pins from the extension region are made available through interface region 503.

Power supply lines and PMIC outputs are routed via section 504 of the interface, which is designed to support future increases in current demand, additional voltage rails, and reconfiguration of power domains. Section 505 comprises dedicated wake-up lines from both the PMIC and processing unit, allowing the input/output board to respond to sleep and wake cycles. Finally, section 506 addresses general-purpose standardization of IO functions-ensuring that signal assignments such as GPIO, ADC, PWM, SPI, I2C and similar outputs from the main circuit board are designed for maximum compatibility with different IO board configurations.

In summary, the system illustrated in Fig. 3 achieves a separation of concerns between processing and interfacing components. It enables modularization at both the hardware and software level, promotes reusability across different ECU types, and supports scalability through the use of configurable population, standardized pin mapping, and functional partitioning. This architecture is particularly suited for evolving vehicular platforms where performance, safety, and reuse are critical considerations.

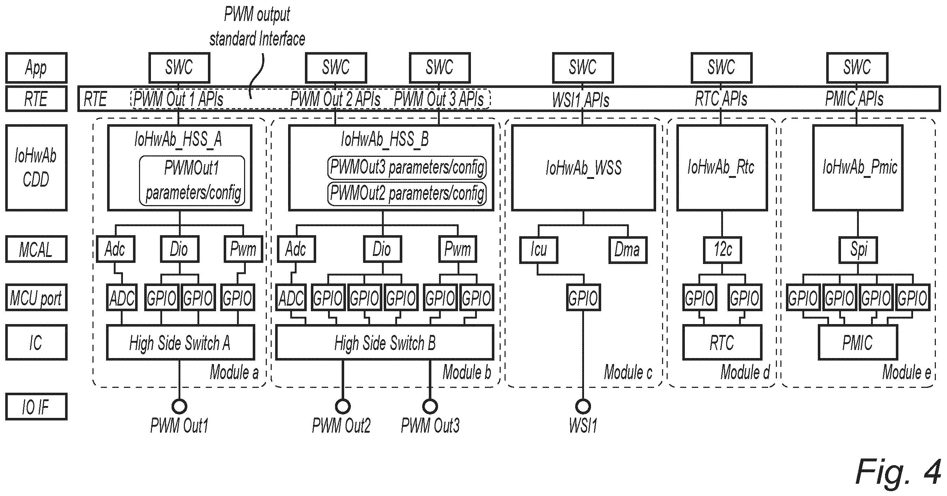

Fig. 4 illustrates an example implementation of IO modularity within the hardware-software architecture of an electronic control unit (ECU). Fig. 4 highlights how input/output (IO) functionality on the IO-specific circuit board may be modularized in conjunction with the software abstraction layers, enabling scalable and reusable ECU implementations.

Each module shown in Fig. 4 represents a distinct IO hardware interface and its associated abstraction software, forming a complete functional unit. These modules are defined based on hardware implementation types and are structured to be functionally independent. For each module, the IO hardware interface (IO IF) is abstracted by a corresponding IO hardware abstraction (IoHwAb) layer, which belongs to the base software (BSW). The IoHwAb layer manages access to microcontroller abstraction layer (MCAL) services and provides standardized interfaces to the runtime environment (RTE), which in turn exposes those interfaces to the application software components (SWC).

Modules a through e exemplify different types of IO functions and their modular integration:
Module a includes a high-side switch (HSS A), controlled via general-purpose input/output (GPIO) ports, pulse-width modulation (PWM), digital IO (Dio), and analog-to-digital converter (ADC) interfaces. All of these are grouped under the abstraction module IoHwAb\_HSS\_A, which encapsulates control, diagnostics, and functional behavior for the hardware instance.

Module b shows a second high-side switch (HSS B) and a separate instantiation of the IoHwAb\_HSS\_B abstraction layer. This module demonstrates reuse of the same interface structure with potentially different hardware, populated or configured as needed per ECU variant.

Module c illustrates a wheel speed sensor interface (WSS1), using input capture unit (ICU) and direct memory access (DMA) elements controlled by the IoHwAb\_WSS module. This abstraction module centralizes timing and signal handling required for wheel speed acquisition.

Module d integrates a real-time clock (RTC), accessed via I2C communication and managed through the IoHwAb\_Rtc abstraction. This encapsulation isolates the clock functionality from the broader system logic, allowing reuse and replacement without systemwide impact.

Module e illustrates a power management integrated circuit (PMIC), interfaced through SPI and accessed via IoHwAb\_Pmic. This module similarly encapsulates the control and diagnostic routines associated with power supervision.

Across all modules, the Fig. 4 illustrates a consistent modularization pattern, where each hardware interface is encapsulated by a self-contained abstraction module, exposing standardized APIs toward the application layer. The architecture supports a parent/child structure, in which each parent IoHwAb module provides a common interface framework, while child modules are instantiated with configuration data specific to a given hardware realization.

This modular approach allows IO functionality to be reused across different ECUs and vehicle variants with minimal integration effort. It supports a high degree of software reusability, even in cases where hardware configurations vary significantly. The integration of child modules per ECU variant introduces some upfront configuration effort, but this is outweighed by the long-term benefits of standardization, scalability, and adaptability in modular vehicle system design

The described SMU (Scalable Modular Unified) ECU Architecture defines a modular, scalable approach to designing electronic control units using at least two printed circuit boards: one or more main circuit boards responsible for processing, and one IO-specific circuit board responsible for vehicle interfacing. The architecture prescribes principles for allocating functionality and integrated components to either board, ensuring a consistent separation between computation and IO. A standardized board-to-board interface governs all electrical and mechanical interconnections between boards, enabling flexible combinations and reusability across different ECU configurations. Strategic ICs, including processing units, are standardized in both hardware and software terms, and special emphasis is placed on modularizing and configuring vehicle IO interfaces to maximize reusability and reduce engineering effort.

By applying the full set of architectural building blocks, ECUs may be efficiently executed using the SMU ECU framework, supporting a wide range of domain functions such as zone control, body control, or propulsion. When extended across multiple ECUs and vehicle platforms, the architecture supports a harmonized electronics strategy that facilitates reuse, platform alignment, and faster time-to-market. The SMU ECU Architecture also supports lifecycle adaptability, allowing for incremental upgrades, vehicle program rollouts, or mid-cycle technology introductions. As illustrated in the example scenarios, this enables seamless updateability across vehicle generations, improving development efficiency and ensuring long-term consistency across the vehicle portfolio.

Example 1. A modular computer system (100) for a vehicle, comprising: a main circuit board (102) comprising a processing unit (104), the main circuit board being configured to perform computation and control functions in a vehicle; an input/output circuit board (106), configured to perform input and output operations for vehicle-specific functions; and a board-to-board interface connecting (108) the main circuit board and the input/output circuit board, wherein the main circuit board and the input/output circuit board are functionally and physically separate, and the input/output circuit board is configured to provide electrical and mechanical interfacing (110) between the vehicle and the main circuit board.

Example 2. The system according to example 1, wherein the input/output circuit board is configured to receive main circuit boards having different configurations.

Example 3. The system according to example 1 or 2, wherein the input/output circuit board comprises a plurality of board-to-board interfaces.

Example 4. The system according to any one of the preceding examples, wherein the processing unit is selected from a group of programmable processing devices comprising a microcontroller unit (MCU), microprocessor unit (MPU), system on a chip (SoC), and field programmable gate array (FPGA).

Example 5. The system according to example 4, wherein the programmable processing device is selected based on a required computational capability of the main circuit board, wherein the required computational capability is dependent a on vehicle-specific function which the computer system is configured to perform.

Example 6. The system according to any one of the preceding examples, wherein the main circuit board further comprises at least one of: a power management integrated circuit (PMIC); a system basis chip (SBC); a power supply; and a crystal/oscillator.

Example 7. The system according to any one of the preceding examples, wherein the input/output circuit board comprises at least one of: a mechanical interface for connecting the input/output circuit board to a vehicle wiring harness; a power supply and distribution section; an analog and/or digital input section; a load control section; a communication interface section; a wireless communication section; a wake-up signal management section; and a latch and fail-safe control section.

Example 8. The system according to example 7, wherein the wake-up signal management section is configured to receive a plurality of wake-up signals from vehicle components and to generate one or more generalized wake-up signals for transmission to the main circuit board via the board-to-board interface.

Example 9. The system according to example 7 or 8, wherein the latch and fail-safe control section is configured to maintain operation of selected output functions on the input/output circuit board in response to a predefined vehicle condition when the processing unit on the main circuit board is inactive or non-operational.

Example 10. The system according to example 9, wherein the latch and fail-safe control section is configured to maintain power to at least one vehicle load via the input/output circuit board in a limp-home mode, the limp-home mode being activated when the main circuit board is unresponsive or in a predefined fault state.

Example 11. The system according to any one of the preceding examples, wherein the board-to-board interface comprises a predefined arrangement of pins including: power supply lines, wake-up signal lines, and spare signal lines for functional expansion.

Example 12. The system according to any one of the preceding examples, wherein the system is integrated in a housing configured with a vehicle-specific mechanical fixation and thermal management interface.

Example 13. The system according to any one of the preceding examples, wherein the system comprises one or more main circuit boards and an input/output circuit board, and wherein each main circuit board is operatively connected to the input/output circuit board, and each main circuit board is configured to control at least one vehicle function.

Example 14. A vehicle comprising a system according to any one of the preceding examples.

Various examples have been described. These and other examples are within the scope of the following claims.

## Claims

1. A modular computer system (100) for a vehicle, comprising:
a main circuit board (102) comprising a processing unit (104), the main circuit board being configured to perform computation and control functions in a vehicle;
an input/output circuit board (106), configured to perform input and output operations for vehicle-specific functions; and
a board-to-board interface connecting (108) the main circuit board and the input/output circuit board,
wherein the main circuit board and the input/output circuit board are functionally and physically separate, and the input/output circuit board is configured to provide electrical and mechanical interfacing (110) between the vehicle and the main circuit board.

2. The system according to claim 1, wherein the input/output circuit board is configured to receive main circuit boards having different configurations.

3. The system according to claim 1 or 2, wherein the input/output circuit board comprises a plurality of board-to-board interfaces.

4. The system according to any one of the preceding claims, wherein the processing unit is selected from a group of programmable processing devices comprising a microcontroller unit (MCU), microprocessor unit (MPU), system on a chip (SoC), and field programmable gate array (FPGA).

5. The system according to claim 4, wherein the programmable processing device is selected based on a required computational capability of the main circuit board, wherein the required computational capability is dependent a on vehicle-specific function which the computer system is configured to perform.

6. The system according to any one of the preceding claims, wherein the main circuit board further comprises at least one of:
a power management integrated circuit (PMIC);
a system basis chip (SBC);
a power supply; and
a crystal/oscillator.

7. The system according to any one of the preceding claims, wherein the input/output circuit board comprises at least one of:
a mechanical interface for connecting the input/output circuit board to a vehicle wiring harness;
a power supply and distribution section;
an analog and/or digital input section;
a load control section;
a communication interface section;
a wireless communication section;
a wake-up signal management section; and
a latch and fail-safe control section.

8. The system according to claim 7, wherein the wake-up signal management section is configured to receive a plurality of wake-up signals from vehicle components and to generate one or more generalized wake-up signals for transmission to the main circuit board via the board-to-board interface.

9. The system according to claim 7 or 8, wherein the latch and fail-safe control section is configured to maintain operation of selected output functions on the input/output circuit board in response to a predefined vehicle condition when the processing unit on the main circuit board is inactive or non-operational.

10. The system according to claim 9, wherein the latch and fail-safe control section is configured to maintain power to at least one vehicle load via the input/output circuit board in a limp-home mode, the limp-home mode being activated when the main circuit board is unresponsive or in a predefined fault state.

11. The system according to any one of the preceding claims, wherein the board-to-board interface comprises a predefined arrangement of pins including:
power supply lines,
wake-up signal lines, and
spare signal lines for functional expansion.

12. The system according to any one of the preceding claims, wherein the system is integrated in a housing configured with a vehicle-specific mechanical fixation and thermal management interface.

13. The system according to any one of the preceding claims, wherein the system comprises one or more main circuit boards and an input/output circuit board, and wherein each main circuit board is operatively connected to the input/output circuit board, and each main circuit board is configured to control at least one vehicle function.

14. A vehicle comprising a system according to any one of the preceding claims.
